(19) Europäisches Patentamt
European Patent Office
Office européen des brevets

(11) EP 4 582 499 A1

(12) EUROPEAN PATENT APPLICATION
published in accordance with Art. 153(4) EPC

(43) Date of publication:
**09.07.2025 Bulletin 2025/28**

(21) Application number: **23881933.8**

(22) Date of filing: **26.10.2023**

(51) International Patent Classification (IPC):
***C09D 11/101*** *(2014.01)* ***C09D 11/30*** *(2014.01)*
***H10K 30/88*** *(2023.01)* ***H10K 50/844*** *(2023.01)*

(52) Cooperative Patent Classification (CPC):
Y02E 10/549

(86) International application number:
**PCT/CN2023/126933**

(87) International publication number:
**WO 2024/088358 (02.05.2024 Gazette 2024/18)**

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**
Designated Extension States:
**BA**
Designated Validation States:
**KH MA MD TN**

(30) Priority: **26.10.2022 CN 202211317763**

(71) Applicant: **Xi'an Smart Materials Co., Ltd.**
**Xi'an, Shaanxi 712099 (CN)**

(72) Inventors:
- **HE, Xin**
  **Shaanxi 712099 (CN)**
- **YAO, Yaoxinbo**
  **Shaanxi 712099 (CN)**
- **WU, Yanyan**
  **Shaanxi 712099 (CN)**

(74) Representative: **Zacco GmbH**
**Bayerstrasse 83**
**80335 München (DE)**

# (54) HIGH-FLEXIBILITY ULTRAVIOLET CURABLE INK AND PACKAGING LAYER THEREOF

(57) Provided are a high-flexibility ultraviolet curable ink and a packaging layer thereof. Raw materials of the ink at least includes in parts by weight: 50 to 90 parts of a light curable silicon-containing monomer, 10 to 40 parts of light curable non-silicon monomers, and 0.01 to 10 parts of a photoinitiator. By using the light curable silicon-containing monomer which do not contain an aromatic ring structure, a stress distribution effect can be achieved under the action of external force by utilizing the strong deformation capacity of an Si-O-Si chain segment of the light curable silicon-containing monomer, so that the plasma etching resistance of a packaging layer is improved, and compared with ultraviolet curable ink containing a benzene ring, the high-flexibility ultraviolet curable ink has higher flexibility and better anti-yellowing performance.



Processed by Luminess, 75001 PARIS (FR)

## Description

## FIELD

The present disclosure relates to the technical field of ultraviolet curable ink, and relates to a high-flexibility ultraviolet curable ink and a packaging layer thereof.

## BACKGROUND

Optoelectronic devices such as organic light-emitting diodes, organic solar cells, and perovskite solar cells are critical to energy revolution and information technology development. The stability, reliability, and lifetime of various new optoelectronic devices under various conditions of use have attracted much attention. Organic and inorganic materials, the core part in various new photoelectric devices, is more susceptible to degradation and deterioration by water and oxygen at micro and nano scales, which seriously reduces the properties and even service life of related devices and components. Therefore, it is critical to avoid the damage of water and oxygen to related devices and components in practical applications.

One way to effectively block the damage of water and oxygen to various new optoelectronic devices is to package them in a suitable manner. A conventional packaging method adopts a rigid glass or metal cover plate; however, the metal cover plate is opaque, and the glass cover plate has poor toughness and is brittle. Therefore, conventional packaging methods are not suitable for packaging flexible electronic devices. Currently, the Barix packaging technology involving a multilayer composite of organic layers and inorganic layers is generally used for packaging flexible electronic devices, and in the multilayer structure, the inorganic layers and the organic layers are sequentially formed. The inorganic layers are formed by plasma deposition, and the organic layers may be etched by plasma, and such etching may impair the packaging function of an organic barrier layer.

The patent Application TW201538596A provides a composition for packaging a light emitting diode and a display fabricated using same. In this patent, a composition for packaging an organic light emitting diode is prepared by a photocurable monomer, a silicon-containing monomer and an initiator, and after curing, it has a low plasma etching rate, a high light transmittance and a photocuring rate. However, a substituent of the silicon-containing monomer in this patent contains an aromatic ring, and thus the cured product has certain rigidity, poor flexibility and poor anti-yellowing performance.

The patent application CN111826024A discloses an ink composition, a packaging structure and a semiconductor device. The ink composition includes a photocurable silicon-containing monomer component, an active diluent component and a photoinitiator component. The prepared ink composition has a higher photocuring rate and a lower curing shrinkage rate after curing. However, its free radical-cation hybrid curing system will cause the cured film to have poor flexibility after curing, which is not conducive to the packaging of flexible electronic devices.

## SUMMARY

The object of the present disclosure is to overcome the described disadvantages of the prior art, and provides a high-flexibility ultraviolet curable ink and a packaging layer thereof, thereby solving the problems of poor flexibility, easy yellowing and a high plasma etching rate of the ink composition after curing in the prior art.

In order to achieve the described object, the present disclosure adopts the following technical solution.

A high-flexibility ultraviolet curable ink, wherein in parts by weight, raw materials at least including 50 to 90 parts of a photocurable silicon-containing monomer, 10 to 40 parts of a photocurable non-silicon monomer, and 0.01 to 10 parts of a photoinitiator.

Further, the photocurable silicon-containing monomer is free of an aromatic ring structure.

Further, the structural formula of the photocurable silicon-containing monomer is as follows:

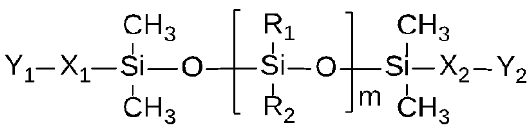

; Formula 1

where $R_1$ and $R_2$ are each independently any one selected from hydrogen, substituted or unsubstituted C1-C50 alkyl, and substituted or unsubstituted C1-C50 alkyl ether groups;

$X_1$ and $X_2$ are each independently any one selected from a single bond, substituted or unsubstituted C1-C50 alkylene, and substituted or unsubstituted C1-C50 alkylene ether groups;

in order to improve the flexibility of the ultraviolet curable ink, $X_1$ and $X_2$ are each independently any one selected from substituted or unsubstituted C5-C12 alkylene and substituted or unsubstituted C5-C12 alkylene ether groups; $Y_1$ is a group of Formula 2, and $Y_2$ is one of hydrogen, substituted or unsubstituted C1-C50 alkyl, substituted or unsubstituted C1-C50 alkyl ether group, or a group of Formula 2; m is an integer of 1 to 10; the Formula 2 is as follows:

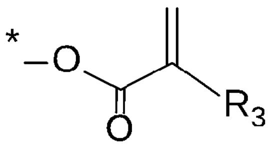
; Formula 2

in the Formula 2, * represents a linking site on compound Si, and $R_3$ is hydrogen or methyl.

Specifically, the photocurable silicon-containing monomer may be represented by at least one of Chemical Formula 1-1 and Chemical Formula 1-2.

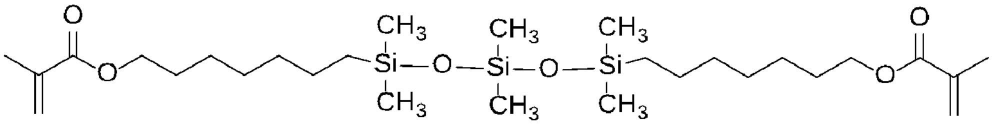
; Formula 1-1

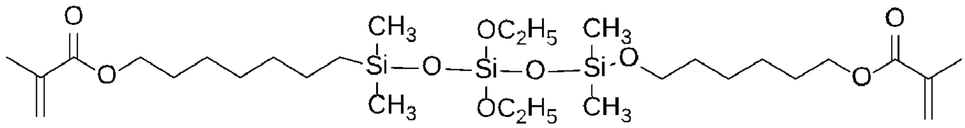
; Formula 1-2

Further, the photocurable non-silicon monomer is a mixture of a photocurable monofunctional non-silicon monomer and a photocurable multifunctional non-silicon monomer.

Further, a mass ratio of the photocurable monofunctional non-silicon monomer to the photocurable multifunctional non-silicon monomer is (10-20): (2-8).

Further, the photocurable monofunctional non-silicon monomer is an alicyclic group-containing mono acrylate monomer or mono methacrylate monomer.

Further, the alicyclic group-containing mono acrylate monomer or mono methacrylate monomer is one or more of 4-tert-butylcyclohexyl acrylate, dicyclopentenyl acrylate, dicyclopentyl methylacrylate, dicyclopentenyl ethoxylated acrylate, dicyclopentenyl ethoxylated methacrylate, 3,3,5-trimethylcyclohexyl acrylate, cyclotrimethylolpropane methylal acrylate, tetrahydrofurfuryl acrylate, tetrahydrofurfuryl methacrylate, isobornyl methacrylate, and cyclohexyl methacrylate.

Further, the photocurable multifunctional non-silicon monomer is one or more of trimethylolpropane triacrylate, pentaerythritol triacrylate, ethoxylated trimethylolpropane triacrylate, propoxylated trimethylolpropane triacrylate, propoxylated glyceryl triacrylate, trimethylolpropane trimethacrylate, ditrimethylolpropane tetraacrylate, polydipentaerythritol pentaacrylate, sorbitol pentaacrylate, and dipentaerythritol hexaacrylate.

Further, a mass ratio of the photocurable silicon-containing monomer to the photocurable non-silicon monomer is (55-85): (20-30).

The term "monofunctional" monomer refers to a monomer containing one photocurable functional group; the term "bifunctional" monomer refers to a monomer containing two photocurable functional groups; and the term "multifunctional" monomer refers to a monomer containing three or more photocurable functional groups.

Further, the photoinitiator is a radical initiator.

Preferably, the free radical initiator is at least one of a triazine-based photoinitiator, an acetophenone-based photoinitiator, a benzophenone-based photoinitiator, a thioxanthone-based photoinitiator, a benzoin-based photoinitiator, a phosphorus-based photoinitiator, and an oxime-based photoinitiator.

Further preferably, the photoinitiator is a phosphorus-based photoinitiator.

Further preferably, the phosphorus-based photoinitiator is one or more of photoinitiator TPO, photoinitiator TEPO, and photoinitiator BAPO.

In order to obtain a high-flexibility ultraviolet curable ink having good properties and meet the process requirements of inkjet printing, further, the high-flexibility ultraviolet curable ink has a viscosity of 15 to 45mPa·S and a surface

tension of 20mN/m to 38mN/m at 25°C.

A packaging layer obtained by photocuring the high-flexibility ultraviolet curable ink of any one of claims 1-9, where a thickness of the packaging layer is 1μm to 20μm.

Compared with the prior art, the present disclosure has the following beneficial effects:

1. The present disclosure uses a photocurable silicon-containing monomer that does not contain an aromatic ring structure and uses strong deformation ability of Si-O-Si chain segment therein to disperse stress when subjected to external force, thereby improving the plasma etching resistance of the packaging layer. In addition, the structure does not contain aromatic rigid groups, and the length of the alkyl chain in the structure is defined, and thus the structure has higher flexibility and anti-yellowing performance than benzene ring-containing ultraviolet curable inks.
2. The present disclosure uses a photocurable silicon-containing monomer that does not contain an aromatic ring structure in combination with a mono (meth) acrylate monomer containing an alicyclic group, which effectively reduces the plasma etching rate and flexibility of the packaging layer while also reducing the number of free small molecules, thereby reducing impurity emissions and water vapor permeability.
3. The packaging layer obtained by the ultraviolet curable ink of the present disclosure has extremely low water vapor permeability and oxygen permeability, and thus can extend the service life of existing electronic devices.
4. In the present disclosure, by using a photocurable monofunctional non-silicon monomer and a photocurable multifunctional non-silicon monomer in a specific ratio, the crosslinking density of the ultraviolet curable ink and the light transmittance of the packaging layer can be effectively improved, and the plasma etching rate can be reduced, thereby satisfying the packaging requirements of electronic devices in the prior art.

## DETAILED DESCRIPTION OF THE EMBODIMENTS

The exemplary examples will be described in detail herein, and the embodiments described in the following exemplary examples do not represent all embodiments consistent with the present disclosure. Rather, they are merely examples of an apparatus that is consistent with some aspects of the disclosure as detailed in the appended claims.

To make a person skilled in the art better understand the technical solutions of the present disclosure, the present disclosure is further described in detail below with reference to examples.

Preparation Example 1

The synthesis route for Formula 1-1 was as follows:

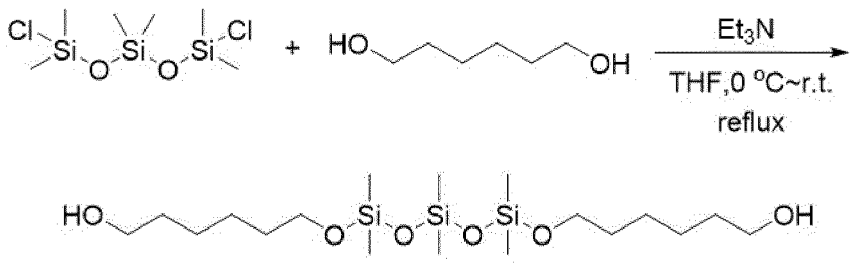


1-A

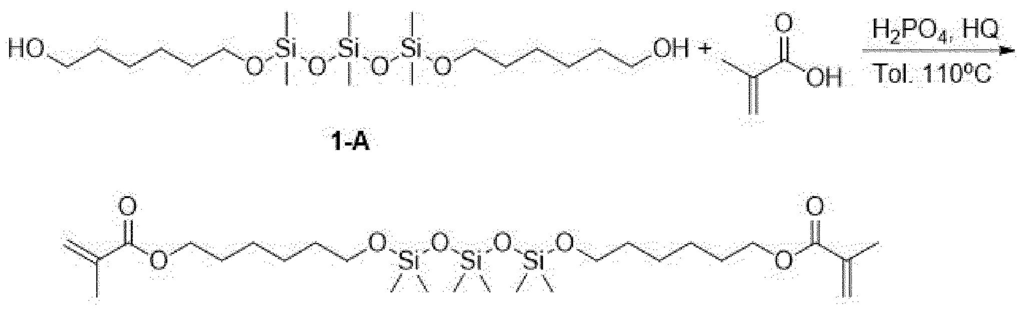


1-A

.

In a reaction flask, 354.5g of 1,6-hexanediol, 273.2g of triethylamine, and 1000mL of THF were added. The mixture was placed in an ice bath at 0°C. The system was replaced with nitrogen three times. 277.4g of 1,5-dichlorohexamethyltrisiloxane was dissolved in 160mL of THF, the resultant was slowly added dropwise into the system, the system was maintained at 0°C to 5°C, the dropwise addition was completed at about 3h, and then the system may be slowly heated to reflux for 20h of reaction. The reaction was monitored by TLC until the reaction of the raw materials was completed. EA was added to dilute the organic phase. The organic phase was washed with dilute HCl and a $Na_2CO_3$ aqueous solution, and then washed once with each of water and saturated brine, and dried with sodium sulfate. The solvent was removed by distillation under reduced pressure. Intermediate 1-A was separated by column chromatography with a yield of 78%.

In a reaction flask, 440.8g of intermediate 1-A, 189.4g of methacrylic acid, 1.96g of concentrated sulfuric acid, 1.1g of hydroquinone, and 200mL of toluene were added. The mixture was refluxed at 110°C to separate water. The reaction was monitored by TLC until the intermediate was completely consumed. After cooling to room temperature, 300mL of diethyl ether was added to dilute the reaction solution, and the reaction solution was washed once with each of 0.2N NaOH solution and water. The organic phase was dried over anhydrous magnesium sulfate. The solvent was removed by distillation under reduced pressure. A target product was separated by column chromatography with a yield of 90%.

Preparation Example 2

The synthesis route for Formula 1-2 was as follows:

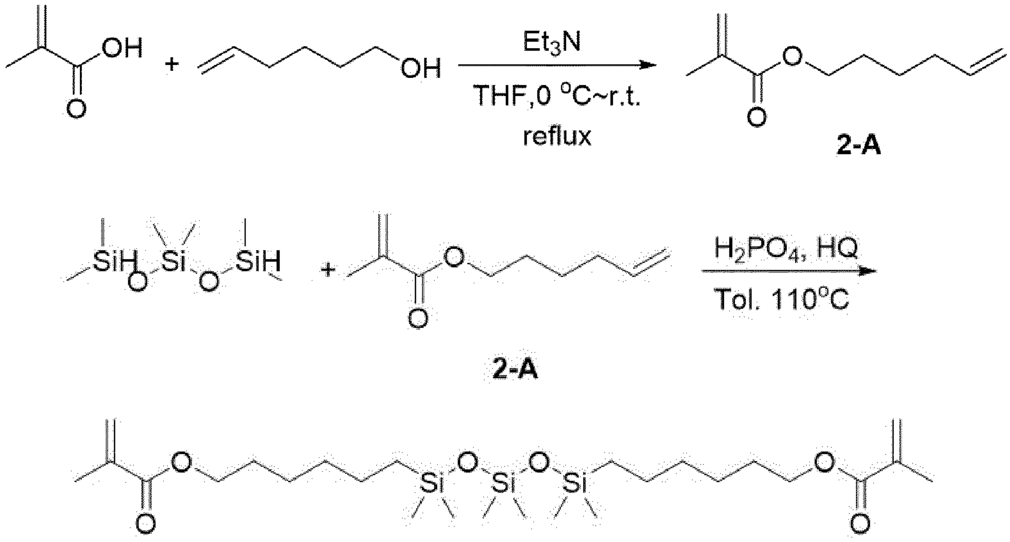


200.3g of 5-hexen-1-ol, 86g of methacrylic acid, 2.5g of hydroquinone, 10g of p-toluene sulfonic acid, and 800mL of toluene were added to a reaction flask equipped with a reflux water separator. The mixture was heated and refluxed for 8h, water was continuously removed until there was substantially no water layered in the water separator, and the reaction was cooled. The reaction was neutralized with sodium acetate anhydrous until the pH of the mixed solution reached about 6, and filtered. The filtrate was distilled under reduced pressure, inorganic salt residues were discarded, 4g of hydroquinone was added to the distillate, and the resultant was distilled under reduced pressure to obtain intermediate 2-A, with a yield of 83%.

Under protection conditions of nitrogen, 168.2g of the intermediate 2-A, 1.5g of PTZ, and 3.8g of Karstedt catalyst were added into a reaction flask. The system was heated to 40 ± 2°C, and 208.5g of 1,1,3,3,5,5-hexamethyltrisiloxane was slowly added dropwise into the system, and reacted for 8h. TLC monitoring was performed until the intermediate was completely consumed. After cooling to room temperature, the target product was distilled under reduced pressure with a yield of 93%.

Example 1

This example provided a high-flexibility ultraviolet curable ink. The raw materials included, in parts by weight, 70 parts of a photocurable silicon-containing monomer, 25 parts of a photocurable non-silicon monomer, and 5 parts of a photoinitiator.

The photocurable silicon-containing monomer was of Formula 1-1 of Preparation Example 1.

The photocurable non-silicon monomer was a mixture of a photocurable monofunctional non-silicon monomer

and a photocurable multifunctional non-silicon monomer, and the weight ratio of the photocurable monofunctional non-silicon monomer to the photocurable multifunctional non-silicon monomer was 15:5.

The monofunctional non-silicon monomer was dicyclopentenyl acrylate, and the photocurable multifunctional non-silicon monomer was pentaerythritol triacrylate, and both were purchased from Shanghai Macklin Biochemical Technology Co., Ltd.

The photoinitiator was photoinitiator TPO, purchased from Sigma-Aldrich (Shanghai) Trading Co., Ltd.

Example 2

This example provided a high-flexibility ultraviolet curable ink. The raw materials included, in parts by weight, 50 parts of a photocurable silicon-containing monomer, 10 parts of a photocurable non-silicon monomer, and 2 parts of a photoinitiator.

The photocurable silicon-containing monomer was of Formula 1-1 of Preparation Example 1.

The photocurable non-silicon monomer was a mixture of a photocurable monofunctional non-silicon monomer and a photocurable multifunctional non-silicon monomer. The weight ratio of the photocurable monofunctional non-silicon monomer to the photocurable multifunctional non-silicon monomer was 20:2.

The monofunctional non-silicon monomer was dicyclopentenyl acrylate, and the photocurable multifunctional non-silicon monomer was pentaerythritol triacrylate, and both were purchased from Shanghai Macklin Biochemical Technology Co., Ltd.

The photoinitiator was photoinitiator TPO, purchased from Sigma-Aldrich (Shanghai) Trading Co., Ltd.

Example 3

This example provided a high-flexibility ultraviolet curable ink. The raw materials included, in parts by weight, 90 parts of a photocurable silicon-containing monomer, 40 parts of a photocurable non-silicon monomer, and 9 parts of a photoinitiator.

The photocurable silicon-containing monomer was of Formula 1-3 of Preparation Example 3.

The photocurable non-silicon monomer was a mixture of a photocurable monofunctional non-silicon monomer and a photocurable multifunctional non-silicon monomer. The weight ratio of the photocurable monofunctional non-silicon monomer to the photocurable multifunctional non-silicon monomer was 15:5.

The monofunctional non-silicon monomer was dicyclopentenyl acrylate, and the photocurable multifunctional non-silicon monomer was pentaerythritol triacrylate, and both were purchased from Shanghai Macklin Biochemical Technology Co., Ltd.

The photoinitiator was photoinitiator TPO, purchased from Sigma-Aldrich (Shanghai) Trading Co., Ltd.

Comparative Example 1

The specific embodiment of Comparative Example 1 was the same as that of Example 1, and differed from Example 1 in that, in Comparative Example 1, the photocurable silicon-containing monomer was:

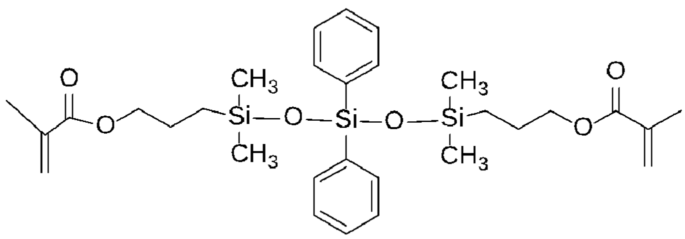

300mL of ethyl acetate, 21g of 3,3-diphenyl-1,1,5,5-tetramethyltrisiloxane, and 43g of allyl alcohol were charged into a reactor. Replacement was performed with nitrogen three times. Then, 72ppm of carbon black-loaded Pt powder was added, and heated to 80°C. The components were stirred for 6h, and the solvent was distilled off. Then, 28.7g of methacryloyl chloride was added into 68g of the obtained compound, 37.1g of triethylamine, and 300mL of dichloromethane while slowly stirring at 0°C. The reaction was performed for 1h, and the solvent was distilled off to obtain a target product.

Comparative Example 2

The specific embodiment of Comparative Example 2 was the same as that of Example 1, except that the amount of the photocurable silicon-containing monomer added was 10 parts.

Comparative Example 3

The specific embodiment of Comparative Example 3 was the same as that of Example 1, except that the photocurable non-silicon monomer in Comparative Example 3 was a photocurable monofunctional non-silicon monomer.

Comparative Example 4

The specific embodiment of Comparative Example 4 was the same as that of Example 1, except that the photocurable non-silicon monomer in Comparative Example 4 was a photocurable multifunctional non-silicon monomer.

Performance testing:

The raw materials of the described Example 1 to 3 and Comparative Examples 1 to 4 were respectively mixed uniformly to obtain ultraviolet curable inks, and then the surface of a material to be packaged was sprayed by an ink-jet printer to a thickness of 10μm, and then was cured by ultraviolet of $30mW/cm^2$ for 60s to form a packaging layer.

(1) Water vapor permeability: The water vapor permeability was measured using a water vapor permeability tester (PERMATRAN-W3/33, manufactured by MOCON) at 85°C and 85% relative humidity for 24 hours.
(2) Plasma etching rate: The compound for thin film packaging was coated onto a silicon wafer for curing, followed by measuring the initial coating height ($T_1$, unit: μm) of the packaging layer. The packaging layer was subjected to plasma treatment under conditions of ICP power: 2500W; RE power: 300W; direct current bias: 200V; Ar flow rate: 50sccm; etching time: 1 minute; and pressure: 10mTorr, and then the height ($T_2$, unit: μm) of the packaging layer was measured. The plasma etching rate of the packaging layer was calculated by the following equation:

$$\text{Plasma etching rate (\%)} = (T_1-T_2)/T_1 \times 100\%$$

where $T_1$ is the initial height of the packaging layer, and $T_2$ is the height of the packaging layer after the plasma treatment.
(3) Fracture toughness ($K_{IC}$): A microcomputer-controlled electronic universal testing machine from Shenzhen Wance Company was used to perform bending performance tests in accordance with GB/T 9341-2008, with a loading speed of $10mm \cdot min^{-1}$. The specimen size was 60mm × 10mm × 3mm, the notch depth was 1mm, and the span was 40mm.
(4) Anti-yellowing performance: The obtained packaging layer was placed in an oven maintained at a temperature of (100 ± 3)°C for 72h, and then the yellowness thereof was tested using a color difference meter, and the whiteness and L, a, and b (L represents brightness, a represents red-green color value, and b represents yellow-blue color value) were measured. The color difference of the thin film before and after yellowing was calculated according to the following equation:

$$\Delta E = \sqrt{\Delta L^2 + \Delta a^2 + \Delta b^2}$$

where in the equation: ΔE represents the comprehensive deviation; ΔL represents the black-white deviation; Δa represents the red-green deviation; and Δb represents the yellow-blue deviation.

The performance test results were shown in Table 1.

Table 1

| | Water vapor permeability ($g/m^2/day$) | Plasma etching rate (%) | Fracture toughness ($K_{IC}$) (MPa·m) | Anti-Yellowing performance (ΔE) |
|---|---|---|---|---|
| Example 1 | 2.7 | 6.5 | 9.35 | 1.29 |

(continued)

| | Water vapor permeability ($g/m^2/day$) | Plasma etching rate (%) | Fracture toughness ($K_{IC}$) (MPa·m) | Anti-Yellowing performance ($\Delta E$) |
|---|---|---|---|---|
| Example 2 | 2.9 | 6.9 | 9.23 | 1.30 |
| Example 3 | 3.0 | 6.9 | 9.16 | 1.34 |
| Comparative Example 1 | 4.1 | 6.6 | 4.14 | 1.69 |
| Comparative Example 2 | 5.6 | 9.4 | 6.27 | 1.43 |
| Comparative Example 3 | 6.1 | 8.7 | 7.43 | 1.56 |
| Comparative Example 4 | 6.4 | 8.1 | 6.15 | 1.59 |

As shown in Table 1, the packaging layers formed by curing the high-flexibility ultraviolet curable inks of the present disclosure have lower water vapor permeability, a lower plasma etching rate, a higher fracture toughness, and excellent anti-yellowing performance. On the contrary, in Comparative Example 1, when a substituent of the photocurable silicon-containing monomer is connected to an aromatic ring (benzene ring), the fracture toughness is obviously reduced, the flexibility thereof is relatively poor, and the anti-yellowing performance property is also obviously deteriorated. In Comparative Example 2, the amount of the photocurable silicon-containing monomer added is small, the plasma etching rate is obviously increased, the water vapor permeability is increased, and the fracture toughness is reduced. In Comparative Example 3 and Comparative Example 4, the photocurable non-silicon monomer is a photocurable monofunctional non-silicon monomer or a photocurable multifunctional non-silicon monomer, and the water vapor permeability, plasma etching rate, fracture toughness and anti-yellowing performance thereof are all poor.

The inventors have found that the types of the components contained in the high-flexibility ultraviolet curable ink and the amounts thereof affect the properties of the ink and the cured film layer thereof, and although the components may have different effects, they are present in the composition at the same time and interact with each other, and therefore it would not have been easy to find a composition having all the desired properties. After extensive research, the inventors propose the aforesaid high-flexibility ultraviolet curable ink. The high-flexibility ultraviolet curable ink has lower water vapor permeability, a lower plasma etching rate, a higher fracture toughness and an excellent anti-yellowing performance.

The foregoing descriptions are merely specific implementations of the present disclosure, so that a person skilled in the art can understand or implement the present disclosure. Various modifications to these embodiments will be readily apparent to a person skilled in the art, and the general principles defined herein may be implemented in other embodiments without departing from the spirit or scope of the disclosure.

It should be understood that the present disclosure is not limited to what has been described above, and that various modifications and changes may be made without departing from the scope thereof. The scope of the disclosure is limited only by the appended claims.

## Claims

1. A high-flexibility ultraviolet curable ink, wherein in parts by weight, raw materials comprising at least 50 to 90 parts of a photocurable silicon-containing monomer, 10 to 40 parts of a photocurable non-silicon monomer, and 0.01 to 10 parts of a photoinitiator.

2. The high-flexibility ultraviolet curable ink of claim 1, wherein the photocurable silicon-containing monomer does not comprising an aromatic ring structure.

3. The high-flexibility ultraviolet curable ink of claim 2, wherein the structural formula of the photocurable silicon-containing monomer is as follows:

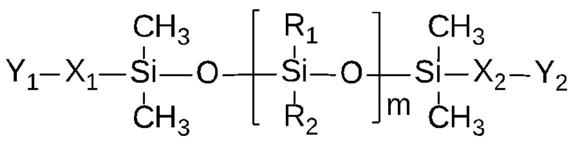

; Formula 1

wherein $R_1$ and $R_2$ are each independently any one selected from hydrogen, substituted or unsubstituted C1-C50 alkyl, and substituted or unsubstituted C1-C50 alkyl ether groups;
$X_1$ and $X_2$ are each independently any one selected from a single bond, substituted or unsubstituted C1-C50 alkylene, and substituted or unsubstituted C1-C50 alkylene ether groups;
$Y_1$ is a group of Formula 2, $Y_2$ is one of hydrogen, substituted or unsubstituted C1-C50 alkyl, substituted or unsubstituted C1-C50 alkyl ether group, or a group of Formula 2; m is an integer of 1 to 10; and the Formula 2 is as follows:

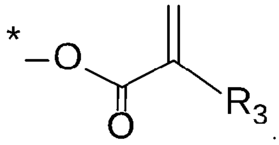
; Formula 2

wherein, * in the Formula 2 represents a linking site on compound Si, and $R_3$ is hydrogen or methyl.

**4.** The high-flexibility ultraviolet curable ink of claim 3, wherein $X_1$ and $X_2$ are each independently any one selected from substituted or unsubstituted C5-C12 alkylene and substituted or unsubstituted C5-C12 alkylene ether groups.

**5.** The high-flexibility ultraviolet curable ink of claim 1, wherein the photocurable non-silicon monomer is a mixture of a photocurable monofunctional non-silicon monomer and a photocurable multifunctional non-silicon monomer.

**6.** The high-flexibility ultraviolet curable ink of claim 5, wherein the photocurable monofunctional non-silicon monomer is an alicyclic group-containing mono acrylate monomer or mono methacrylate monomer.

**7.** The high-flexibility ultraviolet-curable ink according to claim 1, wherein the alicyclic group-containing mono acrylate monomer or mono methacrylate monomer is selected from one or more of 4-tert-butylcyclohexyl acrylate, dicyclopentenyl acrylate, dicyclopentyl methylacrylate, dicyclopentenyl ethoxylated acrylate, dicyclopentenyl ethoxylated methacrylate, 3,3,5-trimethylcyclohexyl acrylate, cyclotrimethylolpropane methylal acrylate, tetrahydrofurfuryl acrylate, tetrahydrofurfuryl methacrylate, isobornyl methacrylate, and cyclohexyl methacrylate.

**8.** The high-flexibility ultraviolet curable ink of claim 1, wherein a mass ratio of the photocurable silicon-containing monomer to the photocurable non-silicon monomer is (55-85): (20-30).

**9.** The high-flexibility ultraviolet curable ink of claim 1, wherein the high-flexibility ultraviolet curable ink has a viscosity of 15mPa· s to 45mPa· s and a surface tension of 20mN/m to 38mN/m at 25°C.

**10.** A packaging layer obtained by photocuring the high-flexibility ultraviolet curable ink of any one of claims 1-9, wherein a thickness of the packaging layer is 1μm to 20μm.

**INTERNATIONAL SEARCH REPORT**

International application No.
**PCT/CN2023/126933**

**A. CLASSIFICATION OF SUBJECT MATTER**

C09D11/101(2014.01)i；C09D11/30(2014.01)i；H10K30/88(2023.01)i；H10K50/844(2023.01)i

According to International Patent Classification (IPC) or to both national classification and IPC

**B. FIELDS SEARCHED**

Minimum documentation searched (classification system followed by classification symbols)

C09D H10K

Documentation searched other than minimum documentation to the extent that such documents are included in the fields searched

Electronic data base consulted during the international search (name of data base and, where practicable, search terms used)

CNABS, CNTXT, DWPI, WPABS, ENTXT, WPABSC, ENTXTC, CNKI, Patentics: 西安思摩威新材料有限公司, 何鑫, 姚新波, 毋妍妍, 油墨, 墨水, 墨汁, 墨液, 墨组合物, 涂料, 涂层, 涂膜, 漆, 铺膜, 涂覆, 覆涂, 涂敷, 铺敷, 成膜, 涂布, 紫外, UV, 芳香, 芳基, 芳族, 苯, 硅, Si, 光固化, 固化, 引发剂, 丙烯酸酯, 封装, ink?, film+, coat+, cover+, paint+, silicon, photocurable, +cur+, +initiator, acrylate

**C. DOCUMENTS CONSIDERED TO BE RELEVANT**

| Category* | Citation of document, with indication, where appropriate, of the relevant passages | Relevant to claim No. |
|---|---|---|
| PX | CN 115595014 A (XI'AN SIMOWEI NEW MATERIALS CO., LTD.) 13 January 2023 (2023-01-13)<br>description, paragraphs [0006]-[0038] | 1-10 |
| PX | CN 115260226 A (XI'AN SIMOWEI NEW MATERIALS CO., LTD.) 01 November 2022 (2022-11-01)<br>description, paragraphs 5-47 and 96-110 | 1-2, 5, 8-10 |
| PY | CN 115260226 A (XI'AN SIMOWEI NEW MATERIALS CO., LTD.) 01 November 2022 (2022-11-01)<br>description, paragraphs 5-47 and 96-110 | 3, 4, 6, 7 |
| X | CN 113563808 A (XI'AN SIMOWEI NEW MATERIALS CO., LTD.) 29 October 2021 (2021-10-29)<br>description, paragraphs 5-85, 93-99, and 139-142 | 1-2, 5, 8-10 |

☑ Further documents are listed in the continuation of Box C. ☑ See patent family annex.

* Special categories of cited documents:
"A" document defining the general state of the art which is not considered to be of particular relevance
"D" document cited by the applicant in the international application
"E" earlier application or patent but published on or after the international filing date
"L" document which may throw doubts on priority claim(s) or which is cited to establish the publication date of another citation or other special reason (as specified)
"O" document referring to an oral disclosure, use, exhibition or other means
"P" document published prior to the international filing date but later than the priority date claimed
"T" later document published after the international filing date or priority date and not in conflict with the application but cited to understand the principle or theory underlying the invention
"X" document of particular relevance; the claimed invention cannot be considered novel or cannot be considered to involve an inventive step when the document is taken alone
"Y" document of particular relevance; the claimed invention cannot be considered to involve an inventive step when the document is combined with one or more other such documents, such combination being obvious to a person skilled in the art
"&" document member of the same patent family

| Date of the actual completion of the international search | Date of mailing of the international search report |
|---|---|
| **01 December 2023** | **07 December 2023** |

| Name and mailing address of the ISA/CN | Authorized officer |
|---|---|
| **China National Intellectual Property Administration (ISA/CN)**<br>**China No. 6, Xitucheng Road, Jimenqiao, Haidian District, Beijing 100088** | Telephone No. |

Form PCT/ISA/210 (second sheet) (July 2022)

INTERNATIONAL SEARCH REPORT

International application No. **PCT/CN2023/126933**

**C. DOCUMENTS CONSIDERED TO BE RELEVANT**

| Category* | Citation of document, with indication, where appropriate, of the relevant passages | Relevant to claim No. |
|---|---|---|
| Y | CN 113563808 A (XI'AN SIMOWEI NEW MATERIALS CO., LTD.) 29 October 2021 (2021-10-29) description, paragraphs 5-85, 93-99, and 139-142 | 3, 4, 6, 7 |
| Y | JP 2015067656 A (SEIREN CO., LTD.) 13 April 2015 (2015-04-13) description, paragraphs 1-11 | 3, 4, 6, 7 |
| A | CN 110294961 A (FOSHAN CITY GREEND CHEMICAL CO., LTD.) 01 October 2019 (2019-10-01) description, paragraphs 4-15 | 1-10 |
| A | CN 111826024 A (HANGZHOU FIRST APPLIED MATERIAL CO., LTD.) 27 October 2020 (2020-10-27) description, paragraphs 12-33 | 1-10 |
| A | JP 2018177904 A (JNC CORP.) 15 November 2018 (2018-11-15) description, abstract | 1-10 |

Form PCT/ISA/210 (second sheet) (July 2022)

**INTERNATIONAL SEARCH REPORT**
**Information on patent family members**

International application No.
**PCT/CN2023/126933**

| Patent document cited in search report | Publication date (day/month/year) | Patent family member(s) | Publication date (day/month/year) |
|---|---|---|---|
| CN 115595014 A | 13 January 2023 | CN 115595014 B | 24 November 2023 |
| CN 115260226 A | 01 November 2022 | None | |
| CN 113563808 A | 29 October 2021 | None | |
| JP 2015067656 A | 13 April 2015 | JP 6186229 B2 | 23 August 2017 |
| CN 110294961 A | 01 October 2019 | CN 110294961 B | 15 February 2022 |
| CN 111826024 A | 27 October 2020 | None | |
| JP 2018177904 A | 15 November 2018 | None | |

Form PCT/ISA/210 (patent family annex) (July 2022)

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description


- TW 201538596 A
- CN 111826024 A